# EUROPEAN PATENT APPLICATION

(11) **EP 2 241 657 A1**
(43) Date of publication of application: **20.10.2010**
(21) Application number: 08865600.4
(22) Date of filing: 08.12.2008
(51) Int. Cl.: C30B 29/06, H01L 21/304

(54) **METHOD FOR MANUFACTURING EPITAXIAL SILICON WAFER**

(30) Priority: 21.12.2007 JP 2007330777
(71) Applicant: SUMCO Corporation, Minato-ku Tokyo 105-8634 (JP)
(72) Inventor: OKUUCHI, Shigeru, Tokyo 105-8634 (JP)
(74) Representative: Deissler, K. Michael
(86) International application number: PCT/JP2008/072276
(87) International publication number: WO 2009/081720

(57) **Abstract**

A silicon oxide film on a wafer front surface, including on internal surfaces of pits, is removed by hydrogen fluoride gas. The pits are thus completely filled with a film growth component at a time of epitaxial film growth. Thereby, productivity is not reduced; wafer flatness is enhanced; and micro-roughness of the wafer front surface is improved.

## Description

### Field of the Invention

The present invention relates to a method of manufacturing an epitaxial silicon wafer, specifically a method of manufacturing an epitaxial silicon water capable of improving wafer flatness properties and wafer surface properties.

### Description of Related Art

In a general manufacturing process of epitaxial silicon wafers, a front surface of a silicon wafer is mirror-polished, and then an epitaxial film is epitaxially grown (film growth) on the wafer front surface. In the method, however, unevenness in thickness of the epitaxial film occurs at the time of epitaxial growth, due to fluctuation of growth gas flow at the time of epitaxial growth. In addition, since source gas moves to a rear surface at the time of epitaxial growth, deposition occurs on the rear surface of the silicon wafer, thus causing a change in surface roughness (increase in a haze value). It is thus considered recently to polish the wafer front surface after the epitaxial growth.

When the method is employed with a mirror-polished wafer for epitaxial growth, however, mirror-polishing is performed once before and once after the epitaxial growth. Thus, productivity of epitaxial silicon wafers might be greatly reduced. It is recently considered to grow an epitaxial film on the front surface of the silicon wafer after etching, taking into consideration film growth at an intermediate process stage and a polish amount of the wafer front surface. A known example of conventional technology focusing on the aspect is Related Art 1.

Related Art 1: Japanese Patent Laid-open Publication No. 2002-043255

### Summary of the invention

### Problem to be solved by the invention

Numerous pits (fine dents) exist on the front surface of the etched silicon wafer. Specifically, in case of acid etching, flatness is damaged on front and rear surfaces of a lapped silicon wafer, and waves and unevenness (peel) of millimeter order are generated on the front surface of the wafer. In case of alkaline etching, pits (facets) are locally generated, the pits having a depth of several µm and a size of about several to several tens µm. Further, a natural oxide film having a thickness of about 5 nm is also formed on the front surface of the etched silicon wafer. Of course, the natural oxide film is formed on an internal surface of each of the pits. Thus, even when an HF solution is contacted on the front surface of the silicon wafer at a time of removal of the natural oxide film, the oxide film on the internal surfaces of the pits is not sufficiently removed, since it is difficult that the HF solution is flown inside the pits.

When the epitaxial film is grown on the front surface of the silicon wafer in the condition, silicon epitaxial growth on the internal surfaces of the pits does not proceed in an ideal manner, because of an impact of the silicon oxide film in the pits. Thus, although a level of the dents is alleviated, the pits (dent deficiency) may remain after the film growth. As a result, even when the front surface of the silicon wafer is mirror-polished again after the epitaxial growth, the pit deficiency may remain on the wafer front surface.

As a result of intense research, the inventor has focused his attention on a hydrogen fluoride gas, which has a higher fluidity than a hydrogen fluoride solution (HF solution). Specifically, the front surface of the silicon wafer is contacted with a hydrogen fluoride gas (gas-phase HF treatment), after etching and before epitaxial film growth. Thereby, the natural oxide film on the internal surfaces of the pits can be removed appropriately, and thus the pits can be filled appropriately with a source gas component at the time of epitaxial growth. The inventor has completed the present invention based on the findings.

The present invention provides a method of manufacturing an epitaxial silicon wafer capable of enhancing wafer flatness, without reducing productivity associated with an increase in the number of processes of polishing a wafer front surface; and further capable of improving micro-roughness (surface roughness) of the wafer front surface.

### Means to solve the problem

A first aspect of the invention provides a method of manufacturing an epitaxial silicon wafer including chamfering an external peripheral surface of a sliced silicon wafer; flattening in which one of lapping and grinding is performed on both a front surface and a rear surface of the silicon wafer subsequent to the chamfering, and thereby flatness of the front surface and the rear surface of the silicon wafer are improved; etching the silicon wafer subsequent to the flattening; performing a gas-phase HF treatment in which the front surface of the silicon wafer is contacted with a hydrogen fluoride gas, subsequent to the etching; and causing epitaxial growth in which an epitaxial film is epitaxially grown on the front surface of the silicon wafer, subsequent to the gas-phase HF treatment.

According to the first aspect of the invention, the front surface of the silicon wafer is contacted with the hydrogen fluoride gas, after the etching and before the epitaxial growth of the epitaxial film. Thereby, a silicon oxide film can be removed from the entire front surface of the wafer, including the silicon oxide film (natural oxide film) on internal surfaces of pits. In removal of the oxide film using a hydrogen fluoride solution, a chemical component does not infiltrate into fine dents because of an impact of surface tension of the solution. Thus, a desired treatment cannot be completely performed on the pits formed on the front surface of the silicon wafer. In the gas-phase treatment using the hydrogen fluoride gas, in contrast, the chemical component can easily infiltrate into the pits (fine areas) due to its chemical properties. Thus, a desired treatment can be achieved in which the silicon oxide film is removed from the internal surfaces of the pits. As a result, a source gas component is contacted not only on a flat portion, but also on the internal surfaces of the pits of the front surface of the silicon wafer at the time of the epitaxial growth. Thereby, the component is epitaxially grown in a good condition, and thus the pits are appropriately filled with the component. Consequently, productivity is not reduced, although the reduction in productivity is a problem of the conventional method of manufacturing epitaxial silicon wafers that includes an increased number of processes of polishing the wafer front surface (two times of front surface polishing before and after epitaxial growth). In addition, wafer flatness is enhanced, and micro-roughness of the wafer front surface is improved.

A monocrystalline silicon wafer, a polycrystalline silicon wafer, and the like can be employed as the silicon wafer. In the flattening, the front and rear surfaces of the silicon wafer may be lapped or ground. In the etching, acid etching or alkaline etching is performed on the entire front surface of the silicon wafer.

To contact the hydrogen fluoride gas on the front surface of the silicon wafer, any method may be employed that allows the hydrogen fluoride gas to treat the wafer front surface. Examples of the method may include to insert the silicon wafer into a sealed container (chamber) filled with hydrogen fluoride gas, and to spray hydrogen fluoride gas only on the front surface of the silicon wafer using a nozzle and the like. An HF concentration in the hydrogen fluoride gas is 0.01 ppm to a saturation state. When the concentration is less than 0.01 ppm, efficiency in removing the silicon oxide film is reduced. A preferable HF concentration in the hydrogen fluoride gas is 0.1 to 100 ppm. Within the range, the oxide film formed in internal walls of the pits is appropriately removed, and dissolved residues are unlikely to remain in the internal walls of the pits. A treatment time of the silicon wafer by the hydrogen fluoride gas is about 4 minutes to 1 hour, which may vary depending on, for instance, the HF concentration of the hydrogen fluoride gas.

Silicon same as the wafer (monocrystalline silicon and polycrystalline silicon) can be employed as a material of the epitaxial film. Alternatively, a material different from the wafer may be employed, such as, for example, gallium, arsenic, and the like. A thickness of the epitaxial film is several µm to several tens µm for bipolar devices, and several µm or less for MOS devices, for example.

In the epitaxial growth, any of a gas-phase epitaxial method, a liquid-phase epitaxial method, or a solid-phase epitaxial method may be employed, for example. As the gas-phase epitaxial method among the above-listed methods, an atmospheric gas-phase epitaxial method, a reduced-pressure gas-phase epitaxial method, an organic metal gas-phase epitaxial method, and the like may be employed.

After the epitaxial growth, the front surface of the epitaxial film may be polished. In the polishing, double-side polishing may be employed in which the front and rear surfaces of the epitaxial silicon wafer are polished simultaneously by a double-side polisher. Alternative polishing may be employed in which only the front surface of the epitaxial silicon wafer on which the epitaxial film exists is polished by a single-side polisher. As a polishing method, single-wafer polishing may be employed in which only a single epitaxial silicon wafer is polished. Alternatively, a batch-type polishing may be employed in which a plurality of epitaxial silicon wafers are simultaneously polished.

A second aspect of the invention provides the method of manufacturing an epitaxial silicon wafer according to the first aspect, wherein, in the gas-phase HF treatment, the silicon wafer and a hydrogen fluoride solution are contained in a sealed container in a non-contact state, and hydrogen fluoride is gasified from the hydrogen fluoride solution.

According to the second aspect of the invention, the silicon wafer and the hydrogen fluoride solution are contained in the sealed container in a non-contact state, and the sealed container is sealed. In the state, hydrogen fluoride is gasified (evaporated) from a liquid surface of the hydrogen fluoride solution. The hydrogen fluoride gas is thus filled in the sealed container, and then the hydrogen fluoride gas is contacted on the front surface (including the internal surfaces of the pits) of the silicon wafer. Thereby, the source gas component is contacted not only on the flat portion, but also on the internal surfaces of the respective pits of the front surface of the silicon wafer. Thus, the component is also epitaxially grown on the internal surfaces of the pits in a good condition, and the pits are completely filled with the component. Since the hydrogen fluoride gas is gasified from the hydrogen fluoride solution in the sealed container, a gas component thereof is unlikely to contaminate a surrounding environment. In addition, facility cost can be lowered.

A preferable material for the sealed container (particularly, material for an inner wall of the container) is a material corrosion resistant to the hydrogen fluoride solution. Examples may include polytetrafluoroethylene (PTFE), a tetrafluoroethylene-perfluoroalkylvinylether copolymer (PFA), polyethylene (PE), polyvinylchloride (PVC), and the like. Any shape of the sealed container and any sealing structure thereof may be employed.

A boiling point of hydrogen fluoride in the hydrogen fluoride solution (hydrofluoric acid) is 19.51 °C. Thus, the sealed container during the gas-phase HF treatment may be left at an ambient temperature. In order to facilitate gasification of hydrogen fluoride, a temperature controller may be mounted to the sealed container so as to control an internal temperature of the container. An adjustment temperature inside the sealed container is 15 °C to 40 °C. When the temperature is less than 15 °C, there is hardly any change from being left at an ambient temperature. When the temperature exceeds 40 °C, water is likely to evaporate, and thus evaporated water is likely to remain on the wafer front surface as droplets. An internal space of the sealed container may be under ordinary pressure, high pressure, or reduced pressure. Any method may be employed to contain the silicon wafer and the hydrogen fluoride solution in the sealed container in a non-contact state. For instance, the silicon wafer may be held in a middle portion or in an upper portion in the sealed container, and the hydrogen fluoride solution may be reserved on a bottom surface of the sealed container. Alternatively, separate portions may be provided to contain the hydrogen fluoride solution and to house the silicon wafer. The hydrogen fluoride gas may be introduced to the silicon wafer housed portion through a connecting pipe connecting the two portions. The silicon wafer may be placed vertically or horizontally inside the sealed container.

A third aspect of the invention provides the method of manufacturing an epitaxial silicon wafer according to the first aspect, wherein, in the gas-phase HF treatment, the hydrogen fluoride gas is sprayed to the front surface of the silicon wafer from a nozzle.

According to the third aspect of the invention, the hydrogen fluoride gas is sprayed to the front surface of the silicon wafer from the nozzle. A large sealed container to house the silicon wafer, as employed in the second aspect, is thus no longer necessary. In addition, the silicon oxide film can be removed only from the wafer front surface (including the internal surfaces of the pits). One or more than one nozzle used may be used. The nozzle may be a fixed type or a movable type (the nozzle is reciprocated above the wafer front surface). Alternatively, the hydrogen fluoride gas may be sprayed to the wafer front surface from a nozzle (fixed type or movable type) provided above, while the silicon wafer is being rotated on a rotation table.

### Effect of the invention

According to the first aspect of the invention, the front surface of the silicon wafer is contacted with the hydrogen fluoride gas, after the etching and before the epitaxial growth of the epitaxial film. Thereby, the silicon oxide film can be removed from the entire front surface of the wafer, including the silicon oxide film on the internal surfaces of pits formed on the wafer front surface. As a result, the film growth component of the source gas is also contacted on the internal surfaces of the pits at the time of the epitaxial growth, and thus the pits are completely filled with the component. Consequently, the wafer flatness is enhanced, without reduction in productivity associated with increase in the number of processes of polishing the wafer front surface. In addition, the micro-roughness of the wafer front surface is improved. Thereby, the high-quality epitaxial silicon wafer can be manufactured at a low cost.

According to the second aspect of the invention in particular, the hydrogen fluoride solution is gasified in the sealed container, and then the generated hydrogen fluoride gas is contacted on the internal surfaces of the pits on the front surface of the silicon wafer. Thus, the gas component thereof is unlikely to contaminate a surrounding environment. In addition, the facility cost can be lowered since the sealed container is used.

Further, according to the third aspect of the invention, the hydrogen fluoride gas is sprayed to the front surface of the silicon wafer from the nozzle. The large sealed container to house the silicon wafer, as employed in the second aspect, is thus no longer necessary. In addition, the silicon oxide film can be removed only from the wafer front surface (including the internal surfaces of the pits).

### Brief Description of the Drawings

Fig. 1 is a flow sheet illustrating a method of manufacturing an epitaxial silicon wafer according to the present invention;
Fig. 2 is a vertical cross-sectional view of a sealed container, illustrating a gas-phase HF treatment using the sealed container in a method of manufacturing an epitaxial silicon wafer according to a first embodiment of the present invention;
Fig. 3 is a flow sheet illustrating the gas-phase HF treatment in the method of manufacturing the epitaxial silicon wafer according to the present invention;
Fig. 4 is a vertical cross-sectional view of a major portion of a gas-phase epitaxial growth apparatus, illustrating epitaxial growth in the method of manufacturing the epitaxial silicon wafer according to the present invention;
Fig. 5 is a perspective view of a double-side polisher having a sun gearless structure used in polishing in the method of manufacturing the epitaxial silicon wafer according to the present invention;
Fig. 6 is a vertical cross-sectional view of a major portion of the double-side polisher having the sun gearless structure used in the polishing in the method of manufacturing the epitaxial silicon wafer according to the present invention; and
Fig. 7 is a vertical cross-sectional view of a rotation table, illustrating a gas-phase HF treatment using a gas spray nozzle in a method of manufacturing an epitaxial silicon wafer according to a second embodiment of the present invention.

### Description of reference numerals

- 10: Epitaxial silicon wafer
- 11: Silicon wafer
- 12: Epitaxial film
- 50: Sealed container
- 51: Hydrogen fluoride solution
- 52: Hydrogen fluoride gas

### Detailed Description of Preferred Embodiments

The embodiments of the present invention are specifically explained below.

### First Embodiment

A method of manufacturing an epitaxial silicon wafer according to the first embodiment of the present invention is specifically explained. In the present embodiment, an epitaxial silicon wafer is produced in which an epitaxial film is grown on a front surface of a silicon wafer. The silicon wafer has a thickness of 725 µm and a diameter of 200 mm; and an axis direction of a main front surface is <100>. The silicon wafer is a p-type wafer.

The silicon wafer is produced by sequentially performing processes below. Specifically, monocrystalline silicon is pulled in the CZ process from a silicon melt in a crucible doped with a predetermined amount of boron. The monocrystalline silicon is subsequently cut into blocks, ground on an external periphery, and then sliced into a plurality of wafers by a wire saw. Thereafter, each wafer is sequentially chamfered, lapped, etched, treated with gas-phase HF, epitaxially grown, double-side polished, finish polished, cleaned, and LPD evaluated.

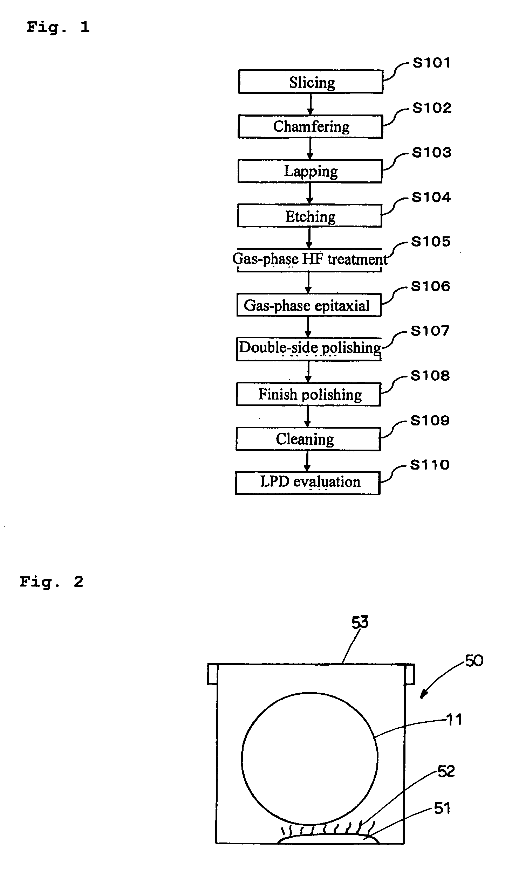

The method of manufacturing the epitaxial silicon wafer is explained below with reference to a flow sheet of Fig. 1. A silicon wafer is first prepared by slicing a monocrystalline silicon ingot pulled in the CZ process (S101). The silicon wafer is added with boron as a dopant, until a specific resistance of the silicon wafer reaches 10 mΩ·cm.

The silicon wafer, which is sliced into a thickness of about 850 µm and a diameter of 200 mm, is then chamfered in a peripheral edge portion thereof by a grind stone for chamfering in a chamfering process (S102). Thereby, the peripheral edge portion of the silicon wafer has predetermined roundness from a cross-sectional view. In a subsequent lapping process, the chamfered silicon wafer is lapped by a lapping plate, using a slurry containing #1000 lapping abrasive grains (S103). In an etching process thereafter, the lapped wafer is immersed in a KOH etching solution having a 48 mol % (80 °C) for 10 minutes (S104). Thereby, deformation in the lapping process, chamfered process, and the like is removed. In this case, the etching is generally performed for about 20 µm on one side and about 40 µm on both sides. Since the etching is alkaline etching using KOH, a plurality of pits having a depth of several µm and a size of about several to several tens µm are locally generated on the front surface of the etched wafer. In addition, a natural oxide film having a thickness of about 5 nm is formed on the front surface of the etched silicon wafer. The natural oxide film is also formed on internal surfaces of the pits.

Subsequently, a gas-phase HF treatment is performed in which a hydrogen fluoride gas is contacted on the front surface of the silicon wafer (S105). Specifically, the silicon wafer 11 and a hydrogen fluoride solution 51 are contained in a non-contact state in a sealed container 50 having a capacity of 50 liters (Fig. 2). The sealed container 50 is a polyethylene (PE) container (wafer case) having corrosion resistance to the hydrogen fluoride solution 51. The sealed container 50 has an open upper surface sealed by a lid body 53. The silicon wafer 11 is placed vertically in a middle portion of the sealed container 50 in a state in which the front and rear surfaces are placed perpendicularly. The sealed container 50 is then closed by the lid, and is left for 5 minutes at an ambient temperature. Thereby, hydrogen fluoride is gasified from a surface of the hydrogen fluoride solution 51 as hydrogen fluoride gas 52, which then fills the sealed container 50.

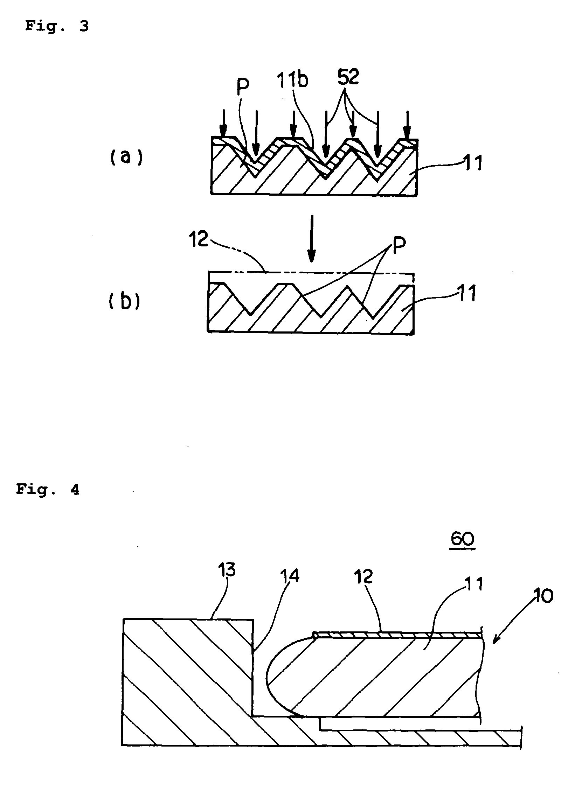

Then, the wafer front surface on which the natural oxide film 11b is formed is contacted with the hydrogen fluoride gas 52. The hydrogen fluoride gas 52 is thus smoothly infiltrated not only on a flat portion, but also into pits P, of the front surface of the silicon wafer 11. Thereby, the hydrogen fluoride gas 52 is also contacted on the natural oxide film 11b formed on the internal surfaces of the pits P (Fig. 3(a)). In removal of the oxide film using the hydrogen fluoride solution 51, however, a chemical component does not infiltrate into fine dents because of an impact of surface tension of the solution. Thus, a desired treatment cannot be completely performed on the pits P formed on the front surface of the silicon wafer 11. In the gas-phase treatment using the hydrogen fluoride gas 52, in contrast, the chemical component can easily infiltrate into the pits P due to its chemical properties. Thus, the natural oxide film 11b can be removed from the internal surfaces of the pits P (Fig. 3(b)).

As a result, a source gas component (silicon) is contacted not only on the flat portion, but also on the internal surfaces of the pits P, of the front surface of the silicon wafer 11 at a time of epitaxial growth hereinafter described. Accordingly, silicon can also be epitaxially grown in a good condition in the process (dashed-two dotted line in Fig. 3(b)). The pits P are thus appropriately filled with the source gas component. Unlike a conventional method, productivity of epitaxial silicon wafers is not reduced, which stems from an increase in the number of processes of polishing the wafer front surface (two times before and after epitaxial growth). In addition, wafer flatness is enhanced, and thus micro-roughness of the wafer front surface (front surface of the epitaxial film 12) is improved. Further, since the hydrogen fluoride gas 52 is gasified from the hydrogen fluoride solution 51 in the sealed container 50, a gas component thereof is unlikely to contaminate a surrounding environment.

After the removal of the oxide film by the hydrogen fluoride gas 52, the silicon wafer 11 is placed in a reaction chamber of a single-wafer type gas-phase epitaxial growth apparatus, under conditions preventing forming of the natural oxide film on the front surface of the silicon wafer 11 (for instance, insertion into the chamber immediately after gas etching, transfer under an inert gas atmosphere or reductive gas atmosphere). Thereby, the epitaxial film 12 is grown on the front surface of the silicon wafer 11 in a gas-phase epitaxial method (S106). The epitaxial growth using the gas-phase epitaxial growth apparatus is specifically explained below with reference to Fig. 4. As shown in Fig. 4, the gas-phase epitaxial growth apparatus 60 has a susceptor 13 provided horizontally in a middle portion of a chamber to which heaters are provided above and below (not shown in the drawing), the susceptor 13 having a circular shape from a plan view. A recess-shaped wafer housing portion 14 is provided in a middle portion of the front surface of the susceptor 13, so as to house the silicon wafer 11 in a state in which its front and rear surfaces are placed horizontally. A pair of gas supply inlets are provided to a first side portion of the chamber to supply a predetermined carrier gas (H₂ gas) and a predetermined source gas (SiHCl₃ gas) to an upper space of the chamber, such that the gases flow in parallel to the wafer front surface. Further, a gas discharge outlet for the both gases is provided to a second side portion of the chamber.

At the time of the epitaxial growth, the silicon wafer 11 is first placed in the wafer housing portion 14 of the susceptor 13, such that the front and rear surfaces of the wafer are provided horizontally. Subsequently, the epitaxial film 12 is grown on the front surface of the silicon wafer 11. Specifically, the carrier gas and the source gas are introduced into the reaction chamber through the corresponding gas supply inlets. An internal pressure of the reaction chamber is set to 100 ± 20 KPa. Silicon, which is produced through pyrolysis or reduction of the source gas, is deposited on the silicon wafer 11 heated to a high temperature of 1,000 °C to 1,300 °C. A reaction rate (deposition rate) of silicon is 1.5 to 4.5 µm/minute. Thereby, the epitaxial film 12 of monocrystalline silicon having a thickness of 20 µm is grown on the front surface of the silicon wafer 11. At the time, the silicon is epitaxially grown in the internal surfaces of the pits P on the front surface of the silicon wafer 11, as described above, and thus the pits P are completely filled with the silicon. Thereby, the epitaxial silicon wafer 10 is produced.

The epitaxial silicon wafer 10 is subsequently placed in a double-side polisher having a sun gearless structure. The front surface of the epitaxial silicon wafer 10 (front surface of the epitaxial film 12) is then mirror-polished. Concurrently, the rear surface of the epitaxial silicon wafer 10 is polished at a higher polishing rate than in the front surface polishing (S107). A polishing solution used herein has a silica concentration of 0.3 weight % or less.

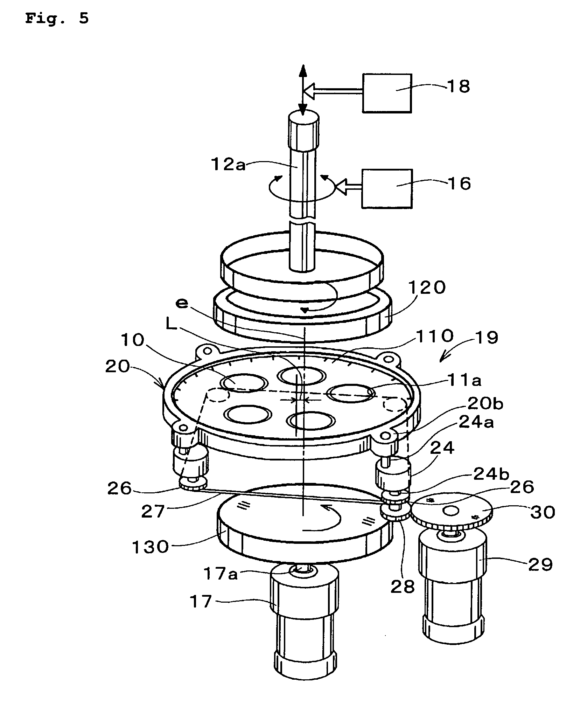

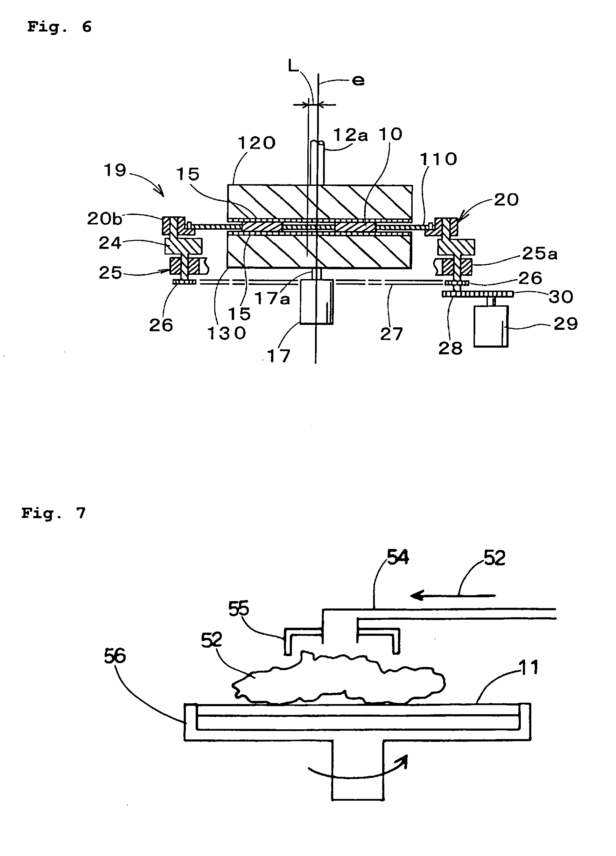

A structure of the double-side polisher having the sun gearless structure is specifically explained below with reference to Figs. 5 and 6. As shown in Figs. 5 and 6, an upper platen 120 is rotated and driven within a horizontal surface, by an upper rotation motor 16 via a rotation axis 12a extended upward. Further, the upper platen 120 is vertically moved up and down by a lift 18, which moves the upper platen 120 in an axial direction. The lift 18 is used to supply and eject the epitaxial silicon wafer 10 to and from a wafer holding hole 11a of a carrier plate 110. A pressure from the upper platen 120 and a lower platen 130 to the front and rear surfaces of the epitaxial silicon wafer 10, respectively, is applied by pressuring devices, such as air bags, and the like provided respectively within the upper platen 120 and the lower platen 130. The lower platen 130 is rotated within a horizontal surface by a lower rotation motor 17 via an output axis 17a thereof. A carrier circular motion mechanism 19 causes the carrier plate 110 to perform a circular motion within a surface parallel to a front surface of the plate 110 (horizontal surface), such that the plate itself is not rotated.

The carrier circular motion mechanism 19 has an annular carrier holder 20 that externally holds the carrier plate 110. The carrier circular motion mechanism 19 and the carrier holder 20 are connected via an interlock structure. Four axis receivers 20b are provided to an external peripheral portion of the carrier holder 20, the axis receivers 20b being projected externally and being provided every 90 degrees. Each of the axis receivers 20b is inserted and fixed with an eccentric axis 24a, which is extended at an eccentric position on an upper surface of an eccentric arm 24 having a small-diameter circular plate shape. A rotation axis 24b is provided perpendicularly at a central portion of a lower surface of each of the four eccentric arms 24. The rotation axis 24b is inserted and fixed to an axis receiver 25a in a state in which an end portion of the rotation axis 24b is projected downward. A total of four axis receivers 25a are provided every 90 degrees to an annular apparatus main body 25. A sprocket 26 is fixed to the end portion projected downward of each of the rotation axes 24b. A timing chain 27 is continuously provided to the sprockets 26 in a horizontal state. The four sprockets 26 and the timing chain 27 rotate the four rotation axes 24b simultaneously, such that the four eccentric arms 24 perform a circular motion synchronously.

One of the four rotation axes 24b is provided with a longer length, such that the end portion is projected downward further than the sprocket 26. A gear 28 for power transmission is fixed to the projected portion. The gear 28 is engaged with a large-diameter gear 30 for driving, which is fixed to the output axis extended upward of a circular motion motor 29. Thus, when the circular motion motor 29 is rotated, a rotation force thereof is transmitted to the timing chain 27, by way of the gears 30 and 28, and the sprocket 26 fixed to the long rotation axis 24b. Then, circumferential rotation of the timing chain 27 synchronously rotates via the remaining three sprockets 26, the four eccentric arms 24 centering the rotation axes 24b within the horizontal surface. Thereby, the carrier holder 20 integrally connected to the eccentric axes 24a, and thus the carrier plate 110 held by the holder 20, perform a circular motion involving no rotation, within the horizontal surface parallel to the plate 110. In other words, the carrier plate 110 circles while being held in an eccentric state having a distance L from an axial line e of the upper platen 120 and the lower platen 130. The distance L is identical to a distance between the eccentric axis 24a and the rotation axis 24b. The circular motion involving no rotation allows all points on the carrier plate 110 to follow a trajectory of a same-size small circle. Thereby, the front and rear surfaces of the epitaxial silicon wafer 10 is polished for 10 µm each side by a polishing cloths 15 provided above and below.

For the double-side polished epitaxial silicon wafer 10, the front surface of the epitaxial film 12 is subsequently finish polished by using a general single-wafer type single-side polisher (not shown in the drawing) (S108). A polish amount of finish polishing is 1 µm. A single-side polisher has a polishing platen and a polishing head, the polishing platen having a polishing cloth for finish polishing stretched on an upper surface, the polishing head being provided immediately above the polishing platen. At the time of the finish polishing, the epitaxial silicon wafer 10 is first fixed to a lower surface of the polishing head via a carrier plate. Then, the rotating polishing head is gradually moved downward while an abrasive agent is being supplied to the polishing cloth. The epitaxial silicon wafer 10 is pressed against the polishing cloth of the rotating polishing platen, and thus finish polished.

Then, the front surface of the epitaxial silicon wafer 10 (front surface of the epitaxial film 12) is cleaned by using an SC1 (NH₄OH/H₂O₂) solution and an SC2 (HCl/H₂O₂) solution as cleaning solutions (S109). After the cleaning, LPD evaluation of the epitaxial film 12 of the epitaxial silicon wafer 10 is performed by using an LPD inspection apparatus (S110). A wafer is determined good when the wafer has 20 or less of an LPD having a diameter of 0.10 µm or larger per wafer.

### Second Embodiment

A method of manufacturing an epitaxial silicon wafer according to the second embodiment of the present invention is explained with reference to Fig. 7. As shown in Fig. 7, the hydrogen fluoride gas 52 is sprayed from a spray nozzle 54 to the front surface of the silicon wafer 11 in the gas-phase HF treatment (S105) in the method of manufacturing the epitaxial silicon wafer according to the second embodiment. Specifically, one silicon wafer 11 is placed on a single-wafer type rotation table 56, and then the rotation table 56 is rotated at a rate of 300 to 500 rpm. One spray nozzle 54 is horizontally reciprocated above the rotation table 56 in a diameter direction of the rotation table 56 at 1 to 2 cm/second for a reciprocation distance of 120 cm. At the time, the hydrogen fluoride gas 52 is supplied from the spray nozzle 54 at a rate of 1 to 2 liter/minute for 4 to 5 minutes. A diameter extension cover 55 having a circular shape from a plan view is fixed to an end portion of the spray nozzle 54, the diameter extension cover 55 externally covering the end portion and extending a spray outlet of the hydrogen fluoride gas 52.

Since the hydrogen fluoride gas 52 is sprayed from the spray nozzle 54 to the front surface of the silicon wafer 11, the large sealed container 50 as used in the first embodiment is no longer necessary. In addition, removal of the silicon oxide film 11b only from the front surface of the silicon wafer 11, including internal surfaces of the pits P, can be performed, although such removal is impossible when the sealed container 50 is used. Other structures, functions, and effects are substantially the same as those in the first embodiment, and thus explanations thereof are omitted.

A difference in LPD counts per epitaxial silicon wafer is reported below with respect to epitaxial silicon wafers produced in the gas-phase HF treatment using the sealed container 50 of the first embodiment (Test Example 1); epitaxial silicon wafers produced in the gas-phase HF treatment using the spray nozzle 54 of the second embodiment (Test Example 2); and epitaxial silicon wafers produced without the gas-phase HF treatment (Comparative Example 1). A KLA-Tencor SP1 was employed as an LPD inspection apparatus. Only LPDs having a diameter exceeding 0.01 µm were counted. Table 1 shows the results. Each numerical value represents an average value of 10 inspected epitaxial silicon wafers.

**[Table 1]**

| | HF treatment method | LPD of 0.1 µm or greater |
|---|---|---|
| Test example 1 | Sealed container type | 2.1 |
| Test example 2 | Single wafer type | 2.5 |
| Comparative example 1 | No treatment after etching | 17.5 |
| | | pcs/wf |

As shown in Table 1, an LPD occurrence rate in Text examples 1 and 2 was less than 15% of the rate in Comparative example 1. It is thus demonstrated that, regardless of method of contacting the hydrogen fluoride gas on the front surfaces of the silicon wafers, performing the gas-phase HF treatment on the front surfaces of the silicon wafers provided epitaxial silicon wafers having fewer LPD counts on front surfaces of epitaxial films and having a good quality.

### Industrial Applicability

The present invention is effective in manufacturing of epitaxial silicon wafers to be used as substrates of devices, such as MOS products, logic products, and the like.

## Claims

1. A method of manufacturing an epitaxial silicon wafer comprising:
chamfering an external peripheral surface of a sliced silicon wafer;
flattening in which one of lapping and grinding is performed on both a front surface and a rear surface of the silicon wafer subsequent to the chamfering, and thereby flatness of the front surface and the rear surface of the silicon wafer are improved;
etching the silicon wafer subsequent to the flattening;
performing a gas-phase HF treatment in which the front surface of the silicon wafer is contacted with a hydrogen fluoride gas, subsequent to the etching; and
causing epitaxial growth in which an epitaxial film is epitaxially grown on the front surface of the silicon wafer, subsequent to the gas-phase HF treatment.

2. The method of manufacturing an epitaxial silicon wafer according to claim 1, wherein, in the gas-phase HF treatment, the silicon wafer and a hydrogen fluoride solution are contained in a sealed container in a non-contact state, and hydrogen fluoride is gasified from the hydrogen fluoride solution.

3. The method of manufacturing an epitaxial silicon wafer according to claim 1, wherein, in the gas-phase HF treatment, the hydrogen fluoride gas is sprayed to the front surface of the silicon wafer from a nozzle.
